(19) Europäisches Patentamt

European Patent Office

Office européen des brevets

(11) EP 1 439 428 A2

(12) EUROPEAN PATENT APPLICATION

(43) Date of publication:
21.07.2004 Bulletin 2004/30

(51) Int Cl.⁷: G03F 7/20

(21) Application number: 04075080.4

(22) Date of filing: 13.01.2004

(84) Designated Contracting States:
AT BE BG CH CY CZ DE DK EE ES FI FR GB GR
HU IE IT LI LU MC NL PT RO SE SI SK TR
Designated Extension States:
AL LT LV MK

(30) Priority: 14.01.2003 EP 03075118

(71) Applicant: ASML Netherlands B.V.
5503 LA Veldhoven (NL)

(72) Inventors:
• Teunissen, Paulus Antonius Andreas
5627 MV Eindhoven (NL)
• Broodbakker, Petrus Johannes Maria
5654 AZ Eindhoven (NL)
• Queens, Rene Marinus Gerardus Johan
5612 KL Eindhoven (NL)

(74) Representative: van Westenbrugge, Andries et al
Nederlandsch Octrooibureau
Postbus 29720
2502 LS Den Haag (NL)

(54) **Level sensor for lithographic apparatus**

(57) A level sensor for a lithographic projection apparatus, the level sensor comprising a light source, a first reflector, a second reflector and a detector, the first reflector being positioned to direct light from the light source towards a wafer surface, and the second reflector being positioned to direct light reflected from the wafer surface to the detector, wherein the first and second reflectors are selected to incur a minimal process dependent apparent surface depression.

EP 1 439 428 A2

## Description

The present invention relates to a level sensor for a lithographic apparatus.

Lithographic projection apparatus are well known in the prior art, and generally comprise:

- a radiation system for supplying a projection beam of radiation;
- a support structure for supporting patterning means, the patterning means serving to pattern the projection beam according to a desired pattern;
- a substrate table for holding a substrate; and
- a projection system for projecting the patterned beam onto a target portion of the substrate.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context.

Generally, the said pattern will correspond to a particular functional layer in a device being created in the target portion, such as an integrated circuit or other device (see below). Examples of such patterning means include:

- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired;
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localised electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required; and

- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper or step-and-repeat apparatus. In an alternative apparatus — commonly referred to as a step-and-scan apparatus — each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate (also referred to as a wafer) that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer).

These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, both incorporated herein by reference.

The projection lens has a large numerical aperture, and consequently has a narrow focus plane. When imaging a pattern onto a substrate it is necessary to ensure that an uppermost surface of the substrate (i. e. the surface onto which the pattern is to be imaged) lies within the focus plane of the projection lens. A level sensor is used determine the position of the uppermost surface of the substrate. If the level sensor indicates that the uppermost surface of the substrate does not lie in the focus plane of the projection lens, the height of the substrate table bearing the substrate is adjusted accordingly.

The level sensor is also used to measure any slope that may be present in the surface of the substrate. The substrate table is tilted accordingly.

The level sensor is an important part of a lithographic projection apparatus. As the wavelengths used by lithographic apparatus become shorter, the focus depth of the projection lens reduces, and the accuracy of the level sensor becomes increasingly important.

Level sensors used for lithographic projection apparatus are subject to process dependency. Process dependency is a form of error in which level sensor measurements provide differing results depending on how a substrate being measured has previously been processed. For example, a level sensor may provide a particular height measurement for a wafer comprising a silicon substrate coated with a single layer of resist, and may provide a different height measurement for a wafer comprising a silicon substrate coated with several layers of resist, even if both wafers are at the same actual height. The error is referred to as process dependent apparent surface depression, and is understood to be caused by an optical effect known as the Goos-Haenchen shift [ref: F. Goos and H. Haenchen, Ann. Phys. 1 (6), 333 (1947)]. The Goos-Haenchen shift is a lateral translation of light along a reflecting surface (in this case the resist) during reflection. The shift is dependent upon the material and layer structure of the substrate, and in addition is wavelength and polarisation dependent. As a result of apparent surface depression a substrate may not be correctly located in the focus plane of the projection lens. When this occurs the resolution of a pattern imaged onto the substrate will be compromised.

Process dependent apparent surface depression is by its nature very difficult to monitor. Although some calibration for process dependency may be performed, residual process dependent apparent surface depression will remain. Different processes give rise to widely varying apparent surface depression, so that a different calibration is needed for each process. In addition, different lithographic apparatus experience widely varying apparent surface depression in response to the same processes (i.e. a given process may give rise to a particular apparent surface depression in one lithographic apparatus, and may give rise to an entirely different apparent surface depression in a different lithographic apparatus). This means that a calibration performed for one lithographic apparatus cannot be used for another lithographic apparatus.

It is an object of the present invention to substantially overcome or mitigate at least one of the above problems.

According to a first aspect of the invention there is provided a level sensor for a lithographic projection apparatus, the level sensor comprising a light source, a first reflector, a second reflector and a detector, the first reflector being positioned to direct light from the light source towards a wafer surface, and the second reflector being positioned to direct light reflected from the wafer surface to the detector, wherein the first and second reflectors are selected to incur a minimal process dependent apparent surface depression.

The term 'light' is not limited to electromagnetic radiation in the visible spectrum, but is intended to cover electromagnetic radiation of any suitable wavelength.

The term 'configuration' is not limited to inherent physical properties of the mirrors, and may include the positions and orientations of the mirrors.

The term 'minimal' is not intended to limit the invention to the case where the process dependent apparent surface depression is substantially zero. Instead, it is intended to mean that for a given reflector type which gives rise to a range of possible apparent surface depressions, the configuration of the reflectors is such that the apparent surface depression lies within a low portion of the range.

The invention has arisen from the inventors' realisation that process dependency of the apparent surface depression is not caused solely by the substrate surface, but is also caused by mirrors of the level sensor (a realisation that is counterintuitive since the mirrors are not modified in any way by wafer processing).

The minimal apparent surface depression may be a net minimum of the apparent surface depression of the combination of the first and second mirrors.

Alternatively, the minimal apparent surface depression may be a net minimum of the apparent surface depression of the combination of the first and second mirrors together with the wafer surface.

According to a second aspect of the invention there is provided a plurality of lithographic projection apparatus comprising:

- a radiation system for providing a projection beam of radiation;
- a support structure for supporting patterning means, the patterning means serving to pattern the projection beam according to a desired pattern;
- a substrate table for holding a substrate; and
- a projection system for projecting the patterned beam onto a target portion of the substrate,

wherein each lithographic apparatus further comprises a level sensor comprising a light source, a first reflector, a second reflector and a detector, the first reflector being positioned to direct light from the light source towards a wafer surface, and the second reflector being positioned to direct light reflected from the wafer surface to the detector, wherein the first and second reflectors for each level sensor are substantially identical, thereby substantially eliminating relative variation of process dependent apparent surface depression between each lithographic apparatus.

The first and second reflectors may be mirrors.

The mirrors may be metallic and may be coated with a transparent material. The term 'transparent' is intended to mean sufficiently transparent, at the wavelength or wavelengths generated by the light source, to enable the level sensor to function correctly.

The material may be an oxide, a fluoride, or any other suitable material. The material may be for example $Al_2O_3$, $MgF_2$ or $SiO_2$.

The material may be $Al_2O_3$ with a thickness of 275+/-40nm, or another material having an equivalent optical thickness.

The material may be $Al_2O_3$ with a thickness of 220+/-40nm on a first mirror and 90+/-40nm on a second mirror. Other thicknesses may be used, with a similar difference between them.

Other materials may be used, with equivalent optical thicknesses.

The mirrors may be Ag, Al, Au or other suitable metallic material.

The mirrors may be Al coated with a layer of native oxide. The term 'coated' is not intended to mean that the layer of native oxide is actively applied. Instead, the layer of native oxide is passively applied.

The pair of reflectors may comprise two surfaces of a prism or pentaprism.

The mirrors may be dielectric mirrors.

According to a further aspect of the invention there is provided a level sensor for a lithographic projection apparatus, the level sensor comprising a light source, a first reflector, a second reflector and a detector, the first reflector being positioned to direct light from the light source towards a wafer surface, and the second reflector being positioned to direct light reflected from the wafer surface to the detector, wherein the reflectors are arranged in pairs, with a configuration that provides substantially zero apparent surface depression for each pair.

Although specific reference may be made in this text to the use of the lithographic apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet (UV) radiation (e.g. with a wavelength of 365, 248, 193, 157 or 126nm) and extreme ultra-violet (EUV) radiation (e.g. having a wavelength in the range 5-20nm), as well as particle beams, such as ion beams or electron beams.

Embodiments of the invention will now be described, by way of example only, with reference to the accompanying schematic drawings in which corresponding reference symbols indicate corresponding parts, and in which:

Figure 1 depicts a lithographic projection apparatus including a level sensor;
Figure 2 depicts a level sensor to which the invention may be applied;
Figure 3 depicts a level sensor and an associated problem identified by the inventors and addressed by the invention;
Figure 4 depicts an alternative level sensor to which the invention may be applied;
Figure 5 depicts part of a level sensor which embodies the invention;
Figure 6 depicts a level sensor which embodies the invention; and
Figures 7, 8 and 9 are graphs which show results obtained using models which are used to construct embodiments of the invention.

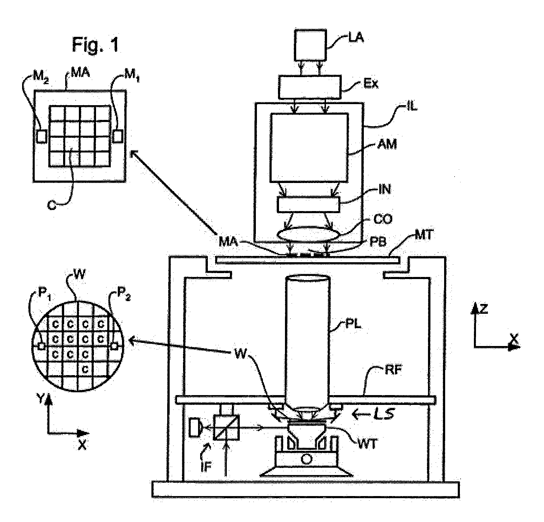

Figure 1 schematically depicts a lithographic projection apparatus 1 according to a particular embodiment of the invention. The apparatus comprises:

- a radiation system Ex, IL, for supplying a projection beam PB of radiation (e.g. UV radiation). In this particular case, the radiation system also comprises a radiation source LA;
- a first object table (mask table) MT provided with a mask holder for holding a mask MA (e.g. a reticle), and connected to first positioning means (not shown) for accurately positioning the mask with respect to item PL;
- a second object table (substrate table) WT provided with a substrate holder for holding a substrate W (e. g. a resist-coated silicon wafer), and connected to second positioning means (not shown) for accurately positioning the substrate with respect to item PL; and
- a projection system ("lens") PL (e.g. a quartz and/ or $CaF_2$ lens system or a catadioptric system comprising lens elements made from such materials, or a mirror system) for imaging an irradiated portion of the mask MA onto a target portion C (e.g. comprising one or more dies) of the substrate W.

As here depicted, the apparatus is of a transmissive type (i.e. has a transmissive mask). However, in general, it may also be of a reflective type, for example (with a reflective mask). Alternatively, the apparatus may employ another kind of patterning means, such as a programmable mirror array of a type as referred to above.

The source LA (e.g. an ArF laser) produces a beam of radiation (e.g. at 193nm). This beam is fed into an illumination system (illuminator) IL, either directly or after having traversed conditioning means, such as a beam expander Ex, for example. The illuminator IL may comprise adjusting means AM for setting the outer and/ or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means (and interferometric measuring means IF), the substrate table WT can be moved accurately, e.g. so as to position different target portions C in the path of the beam PB. Similarly, the first positioning means can be used to accurately position the mask MA with respect to the path of the beam PB, e.g. after mechanical retrieval of the mask MA from a mask library, or during a scan. In general, movement of the object tables MT, WT will be realised with the aid of a long-stroke module (coarse positioning) and a short-stroke module (fine positioning), which are not explicitly depicted in figure 1. However, in the case of a wafer stepper (as opposed to a step-and-scan apparatus) the mask table MT may just be connected to a short stroke actuator, or may be fixed. Mask MA and substrate W may be aligned using mask alignment marks M1, M2 and substrate alignment marks P1, P2.

The depicted apparatus can be used in two different modes:

1. In step mode, the mask table MT is kept essentially stationary, and an entire mask image is projected in one go (i.e. a single "flash") onto a target portion C. The substrate table WT is then shifted in the x and/or y directions so that a different target portion C can be irradiated by the beam PB; and

2. In scan mode, essentially the same scenario applies, except that a given target portion C is not exposed in a single "flash". Instead, the mask table MT is movable in a given direction (the so-called "scan direction", e.g. the y direction) with a speed *v*, so that the projection beam PB is caused to scan over a mask image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

A level sensor, generally indicated as LS in figure 1, is used to measure the height and slope of the uppermost surface of the substrate W. The wafer table WT is raised or lowered, and tilted, accordingly to ensure that the uppermost surface of the substrate W is located in the focus plane of the projection lens PL.

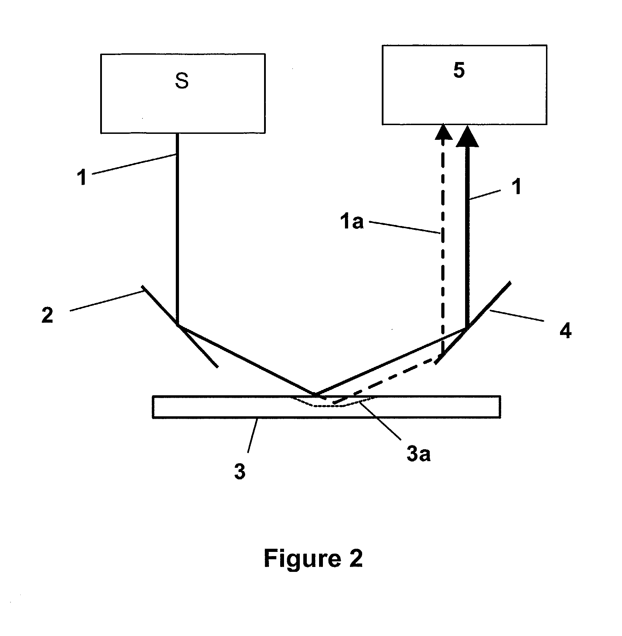

Figure 2 illustrates a level sensor to which the invention may be applied. A beam of light 1 generated by a suitable source S is directed via a folding mirror 2 to a substrate 3. The beam of light 1 is reflected from the surface of the substrate and is directed via a second folding mirror 4 to a detector 5.

A change of height of the surface of the substrate 3 is seen as a displacement of the location at which the beam of light 1 is incident upon the detector 5. For example, if the surface of the substrate is flat then the beam of light 1 is incident upon the centre of the detector 5. If the surface of the substrate includes an indentation, shown by dotted line 3a, then the point at which the beam of light is reflected is displaced, as shown by broken line 1a. An associated translation of the beam of light 1a occurs at the detector 5, indicating that the height of the surface of the substrate has changed. The height of the surface of the substrate 3 is thus closely monitored by the level sensor.

Apparent surface depression arises because the beam of light 1 in general is not entirely directly reflected from the upper surface of the substrate 3. Instead, a portion of the beam of light 1 is translated along the surface of the substrate 3 for a short distance before being reflected (this is known as the Goos-Haenchen shift). Typically, the distance of translation is of the order of one wavelength of the beam of light.

If the distance of the translation were to be consistent then it would be possible to calibrate the level sensor to account for the apparent surface depression. However, it has been found that the apparent surface depression has a strong dependency upon the structure of the surface of the substrate. For example, a silicon wafer coated with photo-resist of a certain thickness and index of refraction will give rise to an apparent surface depression, whereas a substrate comprising a silicon wafer coated with a photo-resist of another thickness and /or index of refraction may give rise to an entirely different apparent surface depression. A substrate comprising a wafer coated with several layers of resist can give rise to an entirely different apparent surface depression.

The process dependency of the apparent surface depression is reduced by ensuring that the beam of light 1 has a broad wavelength band and has a variety of polarisations. The invention provides a further reduction of the process dependency of the apparent surface depression. This is achieved via the selection of the folding mirrors 2, 4 as described below.

The inventors have realised that the folding mirrors 2, 4 of the level sensor are a primary source of process dependency. This would at first sight appear not to be possible, since the folding mirrors 2, 4 do not change in any way when a process is applied to a substrate, but instead always remain the same. Indeed, it would seem to be the case that process dependency must arise entirely from the substrate since the substrate is the only article to which the process has been applied. However, the inventors have realised that the mirrors give rise to an apparent surface depression which is wavelength and polarisation dependent. The process applied to the substrate acts as a filter. The wavelength and polarisation dependent error caused by the reflectors/mirrors is added to the apparent surface depression generated by the substrate surface to give a combined apparent surface depression which will vary from lithography apparatus to lithography apparatus and will vary from process to process. Furthermore, the inventors have realised that appropriate selection of the mirrors will reduce this variation.

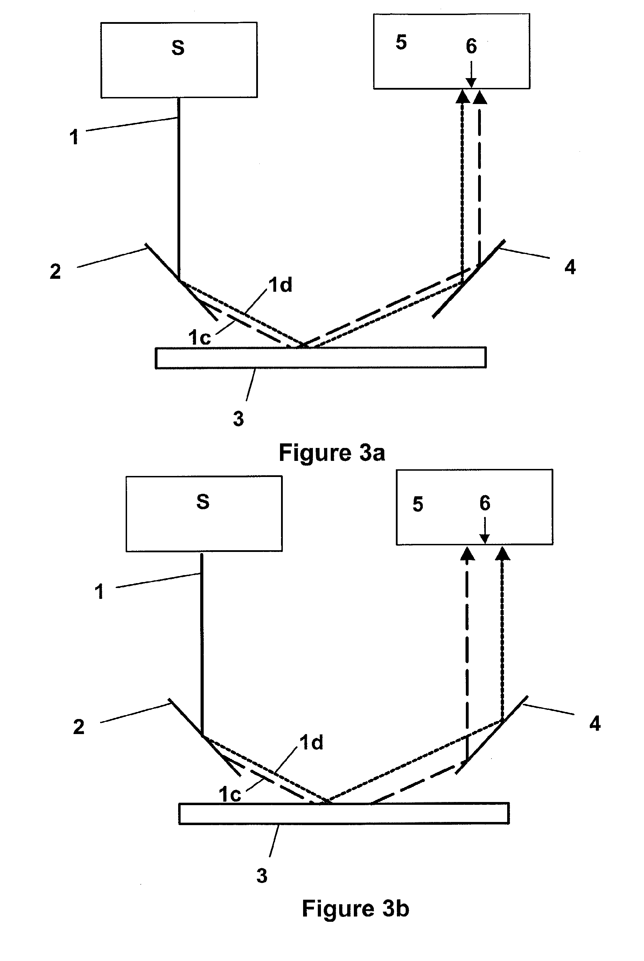

A simplified example of the combined effect of the mirrors and the substrate surface is shown in figure 3. Referring to figure 3a, a light source for a level sensor provides a beam 1 which includes p-polarised light and s-polarised light. Folding mirror 2 has a polarisation dependent Goos-Haenchen shift which causes p-polarised light to be translated (the s-polarised light is not translated). Upon reflection from the folding mirror 2 the beam is separated into two: a translated p-polarised beam as represented by broken line 1c, and an untranslated s-polarised beam as represented by the dotted line 1d. The surface of the substrate 3 reflects the p-polarised beam with an additional slight translation (the s-polarised beam is not translated). The detector 5 detects the p-polarised and s-polarised beams as a single beam with a centre point 6 (assuming that p-polarised and s-polarised beams are of equal intensity). The detected height includes an apparent surface depression which is caused in part by the mirror 2 and in part by the substrate 3.

Figure 3b shows the effect of using the same level sensor to detect a substrate 3 having a different surface. The mirror 2 has the same wavelength dependent Goos-Haenchen shift, but the substrate provides a much larger shift, with the result that the centre point 6 of the detected beam is shifted to the left. When two level sensors are used to measure the substrate of figures 3a and 3b, each level sensor will suffer a different apparent surface depression error, due to differences between the mirrors of the level sensors.

The above example is overly simplified for the purposes of illustration. There are several different aspects which increase the complexity of the apparent surface depression. When the substrate 3 comprises a 'wafer stack' (i.e. a wafer coated with several process layers) it acts as a polarisation filter, preferentially reflecting s-polarised light. This means that the intensities of the p-polarised beam 1c and the s-polarised beam 1d are not equal at the detector 5, causing a shift of the detected centre point 6. In addition, the mirror 4 will give rise to a polarisation dependent Goos-Haenchen shift.

As indicated above, the beam 1 is not a single wavelength but comprises a broad band of wavelengths. The broad band is used because it has been found in the past to reduce apparent surface depression (via averaging of the wavelength dependent Goos-Haenchen shift). A wavelength dependent Goos-Haenchen shift arises at each of the folding mirrors 2,4 and at the surface of the substrate 3. In addition, the folding mirrors 2,4 and especially the substrate 3 may act as wavelength filters.

The polarisation dependent and wavelength dependent Goos-Haenchen shifts, together with the polarisation dependent and wavelength dependent filtering, provided by the folding mirrors 2, 4 and the substrate 3 give rise to an apparent surface depression which has an extremely complicated process dependency.

The apparent surface depression has been found to vary from process to process (i.e. from processed substrate to processed substrate) and from level sensor to level sensor. It had not previously been realised until now that the mirrors provide a significant contribution to the process dependent apparent surface depression.

In addition to realising that the mirrors provide an important contribution to the apparent surface depression, the inventors have realised that this contribution may be mitigated by controlling those parameters of the mirrors which give rise to the Goos-Haenchen shift via the selection of appropriate mirrors.

The selection of appropriate mirrors has a threefold benefit. The mirrors may be selected to provide a level sensor which has a reduced apparent surface depression (for a variety of processed substrates), thereby providing improved level sensing for a given level sensor. Also the mirrors may be selected to provide a level sensor which has apparent surface depression which is robust to small process variations (for example resist and oxide thickness variations). Particularly when levelling needs to be corrected for apparent surface depression by correction values, fewer measurements are needed to determine these correction values as these are applicable on other fields and wafers with the same product.

In addition, where several lithography apparatus are used, machine to machine variation of the process dependent apparent surface depression can be substantially eliminated by ensuring that the mirrors of the level sensors in the lithography apparatus all have the same properties (i.e. all give rise to the same Goos-Haenchen shift).

Thus, in an embodiment of one aspect of the invention, level sensors are provided for a multiplicity of lithography apparatus, the mirrors of the levels sensors having substantially identical optical properties. The mirrors may be metallic, for example Ag, and may be provided with a coating, for example $Al_2O_3$ (other coating materials may be used). The coating has been found by the inventors to give rise to a Goos-Haenchen shift, the wavelength and polarisation dependency of the shift being dependent upon the thickness of the coating. Therefore in this embodiment of the invention the thickness of the coating of the mirrors used for the level sensor is controlled to provide a minimised Goos-Haenchen shift (appropriate thicknesses of $Al_2O_3$ are described further below). A 'family' of level sensors (and the lithographic apparatus to which they are fitted) may be defined for which the mirrors of the level sensors are substantially identical. For example, it may be specified that the mirrors are all fabricated together in a single batch.

An alternative example of metallic mirrors is mirrors having an aluminium coating that is covered with a native oxide. This native oxide grows naturally after deposition of the aluminium coating, when the aluminium coating is exposed to air. The thickness of the aluminium oxide will remain small, typically less than 10nm. It has been found that a thickness of this order provides a Goos-Haenchen shift. However, the thickness of the coating is very consistent from mirror to mirror, thereby providing mirrors with substantially identical properties. It is not desirable to provide a native oxide coating on Ag mirrors, since this will lead to blackening of the surface of the mirrors.

An alternative way in which level sensor mirrors having substantially identical optical properties may be obtained is by using Au mirrors. No coating is needed on Au mirror surfaces, with the result that the Goos-Haenchen shift caused by the mirrors is substantially identical from mirror to mirror.

Eliminating machine to machine variation of process dependent apparent surface depression is particularly advantageous. Currently, a calibration of apparent surface depression may be performed for a lithography apparatus for a substrate to which a particular process (process A) has been applied. The calibration is used for that lithography apparatus each time a substrate is used to which process A has been applied. The calibration is time consuming and costly. When using prior art level sensors, a level sensor of a second lithography apparatus would need to be calibrated separately for process A, and similarly for third, fourth lithography apparatus, etc. Where the first aspect of the invention is applied, i.e. where the mirrors of the level sensors have substantially identical properties, only one level sensor must be calibrated for process A, and the resulting calibration is used for all of the level sensors (i.e. for all of the lithographic apparatus to which the level sensors are fitted). This provides a significant time and cost saving. Similarly, for a substrate to which a different process, process B, has been applied, one level sensor is calibrated and the resulting calibration is used for all of the level sensors (i.e. for all of the lithographic apparatus to which the level sensors are fitted).

In addition to ensuring that the mirrors of different level sensors have substantially identical properties, it is advantageous to provide mirrors which give rise to minimal apparent surface depression. It may appear that this is not necessary, given that a calibration may be performed for each process, which may be used for many level sensors. However, the calibration does not eliminate apparent surface depression. For example, consider a substrate having semiconductor regions and copper regions. Each of these will give rise to a different apparent surface depression, so that although an average apparent surface depression may be calibrated, specific regions of the substrate will still cause the level sensor to suffer different apparent surface depressions.

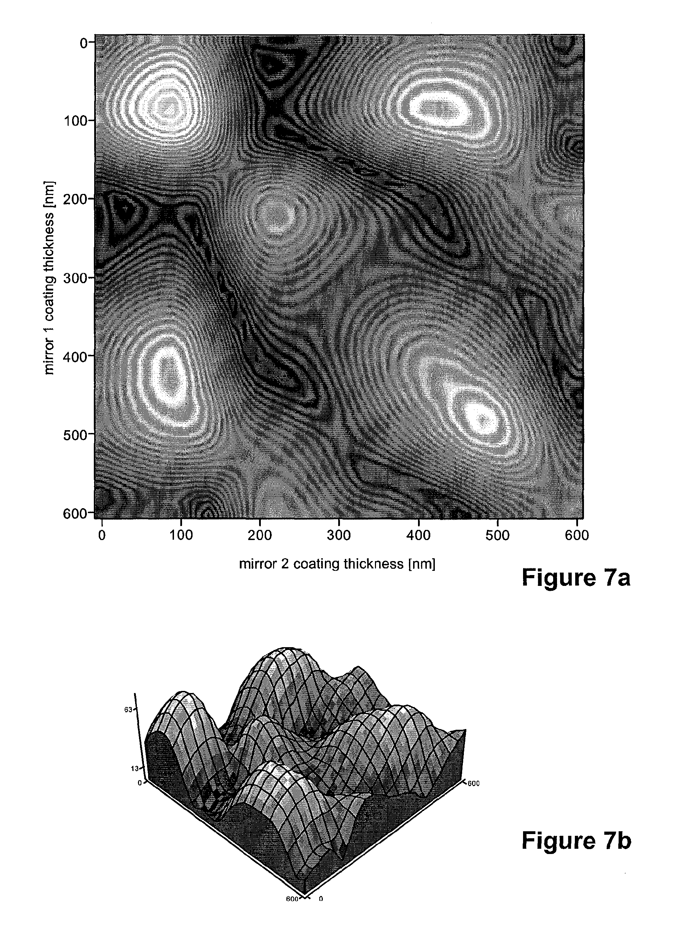

An embodiment of a second aspect of the invention comprises a level sensor provided with mirrors having optical properties which are selected to minimise process dependent apparent surface depression. For example, the second aspect of the invention may be embodied in a level sensor having metallic mirrors. Referring to figure 2, the level sensor comprises a source S, a detector 5, and folding mirrors 2, 4 comprising an Ag substrate with a $Al_2O_3$ coating (other suitable coatings may be used). Coatings have been found by the inventors to give rise to a Goos-Haenchen shift, the wavelength and polarisation dependency of the shift being dependent upon the thickness of the coating. Therefore in this embodiment of the invention the thickness of the $Al_2O_3$ coating of the mirrors used for the level sensor is selected to provide a minimised Goos-Haenchen shift. The appropriate thickness is dependent to some extent upon the processes that have been applied to the substrate 3. However, it has been found that in general a coating of 275nm of $Al_2O_3$ provides favourable results. Other coating thicknesses which provide favourable results are described below in relation to figures 7 to 9.

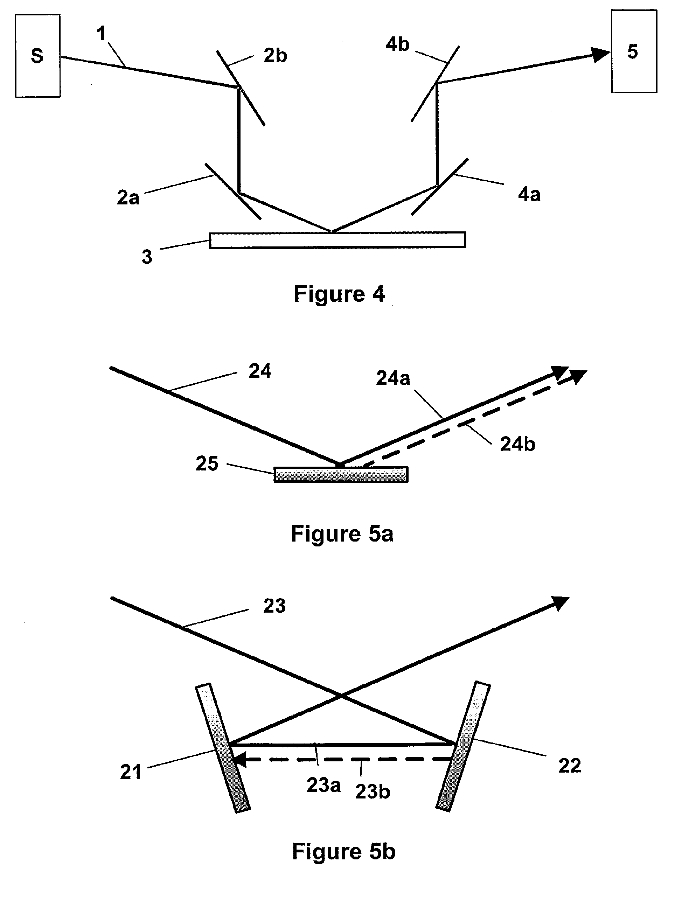

In addition to being applicable to level sensors of the form shown in figure 2, the first and second aspects of the invention may be applied to other forms of level sensor. For example, figure 4 shows an alternative level sensor to which the invention may be applied.

Referring to figure 4, a level sensor comprises a source S, detector 5 and four folding mirrors 2a, 2b, 4a, 4b. It can be seen that the level sensor shown in figure 4 corresponds to that shown in figure 2, except that each folding mirror 2, 4 is replaced with a pair of folding mirrors 2a, 2b, and 4a, 4b.

It will be appreciated that the invention is not restricted to level sensors which use metallic folding mirrors, but may be applied when any form of beam-steering optics is used. The beam-steering optics may for example comprise a prism arranged to allow a beam to enter the prism, and then undergo internal reflection from a face of the prism before leaving the prism at a different angle. The prism may be provided with a coating on the external side of the face which provides the reflection, the coating being controlled according to the invention to provide a minimal Goos-Haenchen shift. Additionally or alternatively, the angle of incidence of the beam into the prism may be adjusted to reduce the Goos-Haenchen shift arising at the prism.

In an alternative embodiment of the invention the metallic mirrors are replaced with fully dielectric mirrors, i.e. mirrors comprising a non-conducting medium. Dielectric mirrors have a zero Goos-Haenchen effect, and so do not contribute to apparent surface depression. Apparent surface depression only occurs for reflecting surfaces that cause a phase jump of reflected light which is dependent on the angle of incidence. In mathematical terms apparent surface depression only occurs when the following condition is satisfied:

$$\frac{\partial \phi}{\partial \theta_i} \neq 0,$$

where $\phi$ is the phase jump (the argument of the complex reflection coefficient) and $\theta_i$ is the angle of incidence of the light beam. For a boundary between air and a dielectric medium (with a purely real refractive index) the derivative is zero. A disadvantage of using dielectric mirrors is that they preferentially reflect s-polarised light, with the result that apparent surface depression caused by the surface of the wafer is accentuated (the averaging effect provided by using all polarisations is lost). An advantage of using dielectric mirrors is that, since the apparent surface depression is caused entirely by the surface of the wafer, machine to machine variations of the apparent surface depression are substantially eliminated.

The dielectric mirror used by the embodiment of the invention comprises a silicon slab which has an anti-reflective coating on its reverse side. The reflection loss caused by the silicon is at an acceptably low level. Dielectric mirrors may be implemented using any suitable material. The embodiment may for example be of the type shown in figure 2 or the type shown in figure 4.

In a further alternative embodiment of the invention, each folding mirror of the level sensor may be replaced with a pair of metallic mirrors. Each pair of metallic mirrors provides a zero net Goos-Haenchen shift, because the mirrors are arranged so that the second mirror provides a Goos-Haenchen shift which is opposite to that provided by the first mirror. An example of a suitable pair of mirrors is shown in figure 5b. Referring to figure 5b, a pair of identical metallic mirrors 21, 22 are symmetrically arranged so that a beam of light 23 is incident upon both mirrors with the same angle of incidence. Since the metallic mirrors 21, 22 are identical, including having the same thickness of coating layer, the Goos-Haenchen shift caused by each mirror cancels out to give a net apparent surface depression of zero. This is effective for every wavelength and every polarisation state, due to the symmetry of the mirror arrangement.

The effect of the mirrors 21, 22 can be understood by comparing them with a single mirror, as shown in figure 5a. Referring to figure 5a, a beam 24 is incident upon a mirror 25. P-polarised light of the beam is translated by the mirror 25 upon reflection, whereas s-polarised light of the beam is not. This gives rise to an s-polarised beam 24a and a p-polarised beam 24b which are spatially separated. In figure 5b, the Goos-Haenchen shift at mirror 22 gives rise to an s-polarised beam 23a and a p-polarised beam 23b. However, due to the symmetry of the mirror configuration, an equal and opposite Goos-Haenchen shift occurs at mirror 21, so that the beams 23a, 23b are recombined to form a single beam 23.

It will be appreciated that there are other configurations of optics which make it possible to use two reflections to substantially eliminate the Goos-Haenchen shift. For example, two internal reflections inside a suitably dimensioned reflecting prism may be used (the prism may have any suitable number of sides).

A disadvantage of this embodiment of the invention, and of that shown in figure 5, is that it occupies extra space as compared to the embodiment of the invention shown in figure 2.

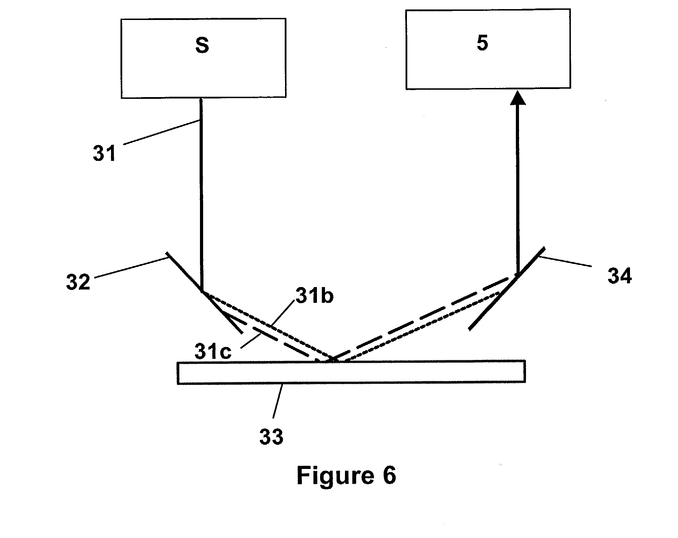

In a further alternative embodiment of the invention a level sensor is constructed using two non-identical metallic mirrors which are chosen such that the Goos-Haenchen shift occurring at the first mirror is at least partially corrected by the Goos-Haenchen shift occurring at the second mirror, thereby leading to a minimal apparent surface depression. This is shown schematically in figure 6. A first mirror 32 of the level sensor gives rise to a shift of the reflection of p-polarised light 31c but not s-polarised light 31b, whereas a second mirror 34 of the level sensor gives rise to a shift of the reflection of s-polarised light 31b but not p-polarised light 31c (for simplicity of illustration a substrate 33 is assumed not to give rise to any shift). The net apparent surface depression caused by the mirrors 32, 34 is zero.

It will be appreciated that in practice there are many variables which complicate the selection of two mirrors to provide a minimal net apparent surface depression (using different mirrors or identical mirrors). Variables which are independent of the mirrors are the angle of incidence of the level sensor beam on the mirrors, the wavelength range of the level sensor beam and the polarisation state of the level sensor beam. Variables of the mirrors themselves are the number of coating layers on the mirrors and the thickness of each coating layer.

The inventors have modelled the effect of coating layer thickness for a level sensor comprising two folding mirrors based on a Ag substrate with an $Al_2O_3$ coating, in a level sensor which uses an unpolarised light beam in the wavelength range 600-1050nm (generated by a halogen lamp). The angle of incidence of the light on the folding mirrors was 55 degrees. The level sensor performance was modelled in relation to a substrate comprising photoresist on silicon and photoresist on aluminium. The angle of incidence of the light on the substrate was 70 degrees.

For a given pair of mirror coating thicknesses, the apparent surface depression caused by the mirrors was determined for a range of resist thicknesses (200-1000nm), first for the silicon and photoresist substrate then for the aluminium and photoresist substrate. This gave two sets of apparent surface depression values. A set of difference values was obtained by subtracting the second set from the first set, and a weighted average of the set was obtained. The model did not include apparent surface depression caused by the substrate.

The graphs shown in figure 7 illustrate that the apparent surface depression exhibits maxima and minima as a function of mirror coating thickness. In figure 7b a peak (light grey region in figure 7a) is indicative of a large error, whereas a trough (dark grey region in figure 7a) is indicative of a small error. It can been seen from figure 7 that all minima are found for non-identical coating thickness combinations. Although the data shown in figure 7 is complex it can be seen that in general terms a reasonably low error will be achieved provided that one of the mirrors is provided with a coating that is around 140nm thicker or thinner than the coating of the other mirror. For example, a first mirror may have a coating which is 70nm thick and the second mirror may have a coating which is 210nm thick. It can be seen from figure 7 that variation of the coating thickness within a reasonable range will still provide a reasonably good performance. A tolerance of +/- 40nm is possible. Modem manufacturing methods allow coating thicknesses to be controlled to within 20nm. This improved control of the coating thickness allows mirror coatings to be made which are located at the centre of an area with minimal error. Reasonable target thicknesses would be 210+/-20nm and 70+/-20nm.

It can be seen from figure 7 that a small error arises when both mirrors are provided with zero thickness (i.e. no) coatings; this is because the metal of the mirrors gives rise to a small Goos-Haenchen shift.

This model indicates mirror-coating thicknesses which will give rise to a minimal apparent surface depression, assuming that no apparent surface depression is caused by the substrate. In practice it is known that the substrate will always give rise to some apparent surface depression, and so this model is of limited utility.

The model is however useful to determine appropriate mirror-coating thicknesses for a level sensor to be fitted in a lithographic apparatus which will be used for a wide variety of processed substrates (since it may not be possible to model the apparent surface depression caused by the substrates).

In some instances it may be known in advance that a lithographic apparatus will be used for a particular given processed substrate. Where this is the case a model may be used to determine the thickness of mirror coatings which provides a minimal apparent surface depression, taking into account the apparent surface depression caused by the substrate.

It will be appreciated that this represents a significant step as compared to above embodiments. Instead of minimising or eliminating the apparent surface depression arising from mirrors, the apparent surface depression arising from the mirrors is used to counteract the apparent surface depression occurring on the substrate (i.e. the net total apparent surface depression is minimised).

The range of solutions for optimum coating stack parameters is large. The optimum choice depends on the angle of incidence of the level sensor beam on the mirrors, the wavelength range and polarisation state of the level sensor beam, the number of coating layers on the mirrors and the thickness of each coating layer. Additional variables are the angle of incidence of the level sensor beam on the substrate, and the expected combination of materials on the substrate.

The inventors have constructed a second model, for a level sensor having two folding mirrors based on a Ag substrate with an $Al_2O_3$ coating, a level sensor beam comprising unpolarised light in the wavelength range 600-1050nm, and a substrate comprising photoresist on silicon and photoresist on aluminium. The angle of incidence of the light on the folding mirrors was 55 degrees. The angle of incidence of the light on the substrate was 70 degrees.

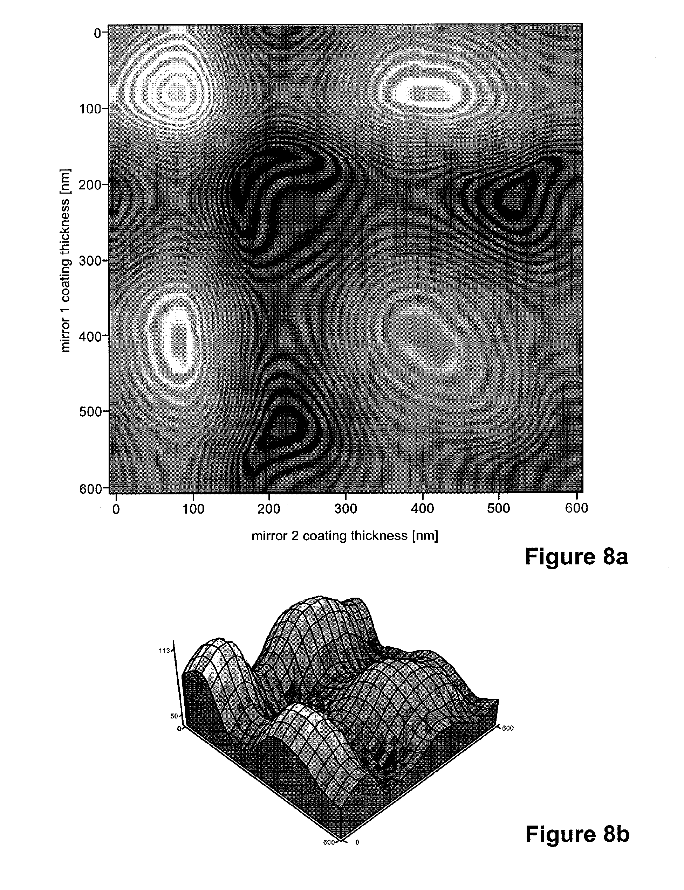

The apparent surface depression effect of mirrors and substrate was calculated averaged over a resist thickness range 200-600nm (the model operated in the same manner as the model described further above, except that the apparent surface depression effect of the substrate was included in the model). Figure 8b shows the effect of varying the coating thickness of the mirrors, peaks indicating large errors and troughs indicating small errors (this is shown two-dimensionally in figure 8a). It can be seen from figure 8 that a minimal error occurs in a region centred approximately on coating thicknesses of 275nm for both mirrors. Figure 8 shows that the range of coating thicknesses for which a minimal error occurs is quite large, roughly 100nm or so, and acceptable results may be expected in that area. In a preferred embodiment of the invention the coating thickness is centred on 275nm with a tolerance of +/- 40nm. Modern coating methods may allow the thickness to be controlled with a tolerance of +/- 20nm. This is preferred because it allows the coating thicknesses to be kept close to the preferred value of 275nm.

When looking at figure 8 it may seem that the choice of the preferred value of 275nm is erroneous, since it does not correspond precisely with the minimum error. However, when selecting the preferred value it is useful to stay away from regions of figure 8 which have large gradients. This is because close proximity to a large gradient may cause a large error to occur in the event of a small change of the system, for example a small change in the thickness of the oxide layer provided on the substrate. The choice of 275nm is optimal based on a combination of a small error and a small gradient.

It can be seen from Figure 8 that a low error occurs in regions where one mirror has a coating thickness of approximately 275nm and the other has a coating thickness of approximately 520nm. This region may also be used to achieve a low error, although it may be difficult to control the thickness of the coating at 520nm (the thicker a coating is, the harder it is to control the thickness).

The second model was determined for a particular substrate, i.e. photoresist-on-silicon with a thickness range of 200nm-600nm. Where it is known that a lithographic apparatus (and the level sensor fitted to it) are to be used for this substrate, the model may be used to select appropriate mirrors for the level sensor, for example with coatings 275nm thick. Where it is known that a lithographic apparatus (and level sensor) are to be used for a different substrate, the model may be modified to determine appropriate mirrors for the level sensor. In this way the mirrors may be tailored to be optimal for those processed substrates for which it is intended to use a given lithographic apparatus.

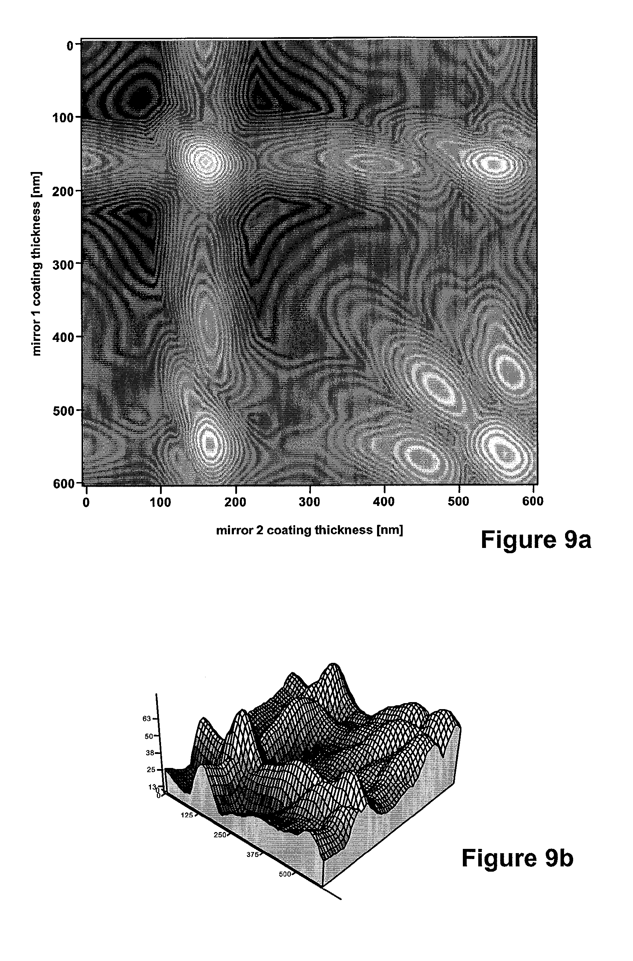

For reasons mentioned above, consistency between level sensors of different lithographic apparatus of a 'family' is important. It is always desirable to minimise differences between lithographic machines, so called machine-to-machine variations. The inventors adapted the model to measure variation of the apparent surface depression effect between two machines, as a function of the thickness of the oxide coatings on the mirrors of the level sensor. Figure 9 shows the results generated by the model. Referring to figure 9 it can be seen that areas with minimal machine-to-machine error are centred on oxide thicknesses of 75nm and 240nm for both mirrors, or a combination of 75nm on one mirror and 240nm on the other mirror. The results shown in figure 9 are in effect $Al_2O_3$ thicknesses which are optimised for manufacturing tolerances.

Taking into account the results found from the model, as shown in figures 7 to 9, it has been determined that if two mirrors with the same coating thickness are to be used, then the best thickness for the coating is 275nm. The accuracy with which the coating thicknesses can be applied may vary from +/-40nm to +/- 20nm.

Taking into account the results found from the model, as shown in figures 7 to 9, it has been determined that if two mirrors with different coating thickness are to be used, then the difference between the thicknesses should be around 130nm. For example, a first mirror may have a coating which is 90nm thick and the second mirror may have a coating which is 220nm thick. These values differ slightly from those obtained in relation to figure 7. This is in order to provide an improved machine-to-machine variation. The accuracy with which these coating thicknesses can be applied may vary from +/-40nm to +/- 20nm.

Machine-to-machine variation is improved by increasing the accuracy with which the thickness of the coating is controlled. This is another reason why well controlled thicknesses are preferred.

As mentioned above the preferred values of coating thickness may be dependent upon the angle of incidence of light on the folding mirrors of the level sensor, or on the angle of incidence of the light on the substrate. Both of these have been investigated using the model developed by the inventors. It was found that variation by +/- 5 degrees of the angle of incidence of light on the folding mirrors (55 degrees) did not significantly modify the output of the model. Similarly, it was found that variation by +/- 5 degrees of the angle of incidence of the light on the substrate (70 degrees) did not significantly modify the output of the model. It can be concluded therefore that the selection of the coatings for the mirrors is applicable for a substantial range of angles of incidence.

The preferred values of coating thickness were determined using a model based upon Ag mirrors. The inventors have substituted Al mirrors for the Ag mirrors, and have found that the preferred values of coating thickness remain the same.

The preferred values of coating thickness were determined using $Al_2O_3$. It will be appreciated that different materials may be used to provide the coating, for example $SiO_2$ or $MgF_2$. An important property of the material is that it is transparent, i.e. sufficiently transparent at the wavelength or wavelengths generated by the light source to enable the level sensor to function correctly. Where a material other than $Al_2O_3$ is used, the preferred values of the coating thickness should be adjusted to take account of differences of refractive index between the material used and $Al_2O_3$. In other words, the optical thickness of the oxide layer should be equivalent to that of the $Al_2O_3$ layer. The term 'optical thickness' is intended to mean the product of the thickness of a material and the refractive index of that material. For example, the refractive index of $Al_2O_3$ is 1.57 at a wavelength of 800nm (this is the central wavelength of the light used by the level sensor of the embodiment of the invention). The optical thickness of a 275nm layer of $Al_2O_3$ is therefore 275 x 1.57, which is 432nm. For this example, if a material other than $Al_2O_3$ is used, the thickness of the material should be selected to provide an optical thickness of 432nm.

Whilst specific embodiments of the invention have been described above, it will be appreciated that the invention may be practiced otherwise than as described. The description is not intended to limit the invention.

## Claims

1. A level sensor for a lithographic projection apparatus, the level sensor comprising a light source, a first reflector, a second reflector and a detector, the first reflector being positioned to direct light from the light source towards a wafer surface, and the second reflector being positioned to direct light reflected from the wafer surface to the detector, wherein the first and second reflectors are selected to incur a minimal process dependent apparent surface depression.

2. A plurality of lithographic projection apparatus comprising:

   - a radiation system for providing a projection beam of radiation;
   - a support structure for supporting patterning means, the patterning means serving to pattern the projection beam according to a desired pattern;
   - a substrate table for holding a substrate; and
   - a projection system for projecting the patterned beam onto a target portion of the substrate,

   wherein each lithographic apparatus further comprises a level sensor comprising a light source, a first reflector, a second reflector and a detector, the first reflector being positioned to direct light from the light source towards a wafer surface, and the second reflector being positioned to direct light reflected from the wafer surface to the detector, wherein the first and second reflectors for each level sensor are substantially identical, thereby substantially eliminating relative variation of process dependent apparent surface depression between each lithographic apparatus.

3. An apparatus according to claim 1 or claim 2, wherein the first and second reflectors are mirrors.

4. An apparatus according to claim 3, wherein the mirrors are metallic and are coated with a transparent material.

5. An apparatus according to claim 4, wherein the material is one of $Al_2O_3$, $MgF_2$ or $SiO_2$.

6. An apparatus according to claim 3 or claim 4, wherein the coating on each of the mirrors is $Al_2O_3$ of 275+/-40nm thickness, or another material having an equivalent optical thickness.

7.  An apparatus according to claim 3 or claim 4, wherein different thicknesses of coatings are provided on each mirror, the coating on the mirrors being $Al_2O_3$ and the difference in thickness being 130+/-40nm.

8.  An apparatus according to claim 7, wherein one of the mirrors has a coating which is 90+/-40nm thick and the other mirror has a coating which is 220+/-40nm thick.

9.  An apparatus according to claim 3 or claim 4, wherein different thicknesses of coatings are provided on each mirror, the coating on the mirrors being a material other than $Al_2O_3$ and the difference in thickness being optically equivalent to 130+/-40nm of $Al_2O_3$.

10. An apparatus according to claim 9, wherein one of the mirrors has a coating which is optically equivalent to 90+/-40nm thickness of $Al_2O_3$. and the other mirror has a coating which is optically equivalent to 220+/-40nm thickness of $Al_2O_3$.

11. An apparatus according to any of claims 4 to 10, wherein the metallic mirrors are Ag.

12. An apparatus according to any of claims 4 to 10, wherein the metallic mirrors are Al.

13. An apparatus according to claim 4, wherein the mirrors are A1 and are coated with a layer of native oxide.

14. An apparatus according to claim 3, wherein the mirrors are Au.

15. An apparatus according to claim 3, wherein the mirrors are dielectric mirrors.

16. A level sensor for a lithographic projection apparatus, the level sensor comprising a light source, a first reflector, a second reflector and a detector, the first reflector being positioned to direct light from the light source towards a wafer surface, and the second reflector being positioned to direct light reflected from the wafer surface to the detector, wherein the reflectors are arranged in pairs, with a configuration that provides substantially zero apparent surface depression for each pair.

17. An apparatus according to claim 16, wherein the pair of reflectors comprises two surfaces of a prism or pentaprism.

Fig. 1

**Figure 2**

**Figure 3a**

**Figure 3b**

Figure 4

Figure 5a

Figure 5b

**Figure 6**

mirror 2 coating thickness [nm]

**Figure 7a**

**Figure 7b**

mirror 1 coating thickness [nm]

mirror 2 coating thickness [nm]

**Figure 8a**

**Figure 8b**

Figure 9a

Figure 9b